# EUROPÄISCHE PATENTSCHRIFT

(11) **EP 1 284 019 B1**
(45) Veröffentlichungstag und Bekanntmachung des Hinweises auf die Patenterteilung: **26.09.2007**
(21) Anmeldenummer: 01940224.7
(22) Anmeldetag: 10.05.2001
(51) Int. Cl.: H01L 29/06, H01L 29/735, H01L 29/739

(54) **HALBLEITER-LEISTUNGSBAUELEMENT**
SEMICONDUCTOR POWER COMPONENT
COMPOSANT SEMI-CONDUCTEUR DE PUISSANCE

(30) Priorität: 16.05.2000 DE 10023956
(43) Veröffentlichungstag der Anmeldung: 19.02.2003
(73) Patentinhaber: ROBERT BOSCH GMBH, 70442 Stuttgart (DE)
(72) Erfinder: FEILER, Wolfgang, 72766 Reutlingen (DE)
(86) Internationale Anmeldenummer: PCT/DE2001/001774
(87) Internationale Veröffentlichungsnummer: WO 2001/088992

(56) Entgegenhaltungen:
- EP-A- 0 576 001
- PATENT ABSTRACTS OF JAPAN vol. 2000, no. 04, 31. August 2000 (2000-08-31) & JP 2000 022175 A (TOSHIBA CORP), 21. Januar 2000 (2000-01-21) & US 6 150 702 A (FUNAKI ET AL.) 21. November 2000 (2000-11-21)
- KOICHI ENDO ET AL: "A 500V 1A 1-CHIP INVERTER IC WITH A NEW ELECTRIC FIELD REDUCTION STRUCTURE" PROCEEDINGS OF THE INTERNATIONAL SYMPOSIUM ON POWER SEMICONDUCTOR DEVICES (ISPSD). DAVOS, CH, MAY 31 - JUNE 2, 1994, NEW YORK, IEEE, US, Bd. SYMP. 6, 31. Mai 1994 (1994-05-31), Seiten 379-383, XP000505841 ISBN: 0-7803-1495-6 in der Anmeldung erwähnt

## Beschreibung

### Stand der Technik

Die Erfindung betrifft ein Halbleiter-Leistungsbauelement mit einem zwischen Hochspannungsseite und Niederspannungsseite angeordneten REduced SURface Field (RESURF)-Gebiet.

Bei dem Halbleiter-Leistungsbauelement könnte es sich beispielsweise um eine Diode, einen LIGBT, einen LDMOS oder auch einen Bipolar-Transistor handeln.

Lateral aufgebaute Leistungsbauelemente umfassen häufig ein RESURF-Gebiet mit einer definierten Dotierungsdosis, die in einem wannenförmigen Verlauf des Feldstärkebetrages an der Halbleiteroberfläche des RESURF-Gebietes und einem über weite Teile linearen Verlauf des Potentials resultiert. Dieser Effekt wird zur Realisierung einer hohen Sperrfähigkeit auf minimaler Chipfläche ausgenutzt. Charakteristischerweise weisen derartige Leistungsbauelemente eine Finger-Interdigitalstruktur auf, so dass die Hochspannungsseite und die Niederspannungsseite fingerförmig ineinandergreifen und durch das die Sperrspannung aufnehmende RESURF-Gebiet voneinander getrennt sind.

In der Literaturstelle "J.A. Appels et al., IEDM Tech. Dig., 1979 Seiten 238-241" wird das RESURF-Prinzip zum Erreichen einer hohen Sperrspannungsfestigkeit bei geringstem Platzbedarf für flache pn-Übergänge beschrieben.

In der Literaturstelle "Endo, K. et al., ISPSD '94 Conference Proc., Seiten 379-383" wird ein spiralförmiger Poly-Silizium-Widerstand beschrieben, der als Hochspannungs-Passivierung über dem RESURF-Gebiet einer SOI-Lateral-Diode, eines SOI-LDMOS sowie eines SOI-LIGBT angeordnet ist. Im Falle des LDMOS und des LIGBT ist der Poly-Silizium-Widerstand auf der einen Seite mit der Anode verbunden und auf der anderen Seite mit dem Gate. Im Falle der Diode ist die eine Seite des Poly-Silizium-Widerstandes mit der Anode und die andere Seite mit der Kathode verbunden. In allen drei beschriebenen Fällen dient der Poly-Silizium-Widerstand zur Erhöhung der Hochspannungsfestigkeit flacher pn-Übergänge.

Beim Einsatz von Leistungsbauelementen der hier in Rede stehenden Art tritt oftmals die Notwendigkeit auf, eine Signalübertragung von der Hochspannungsseite zur Niederspannungsseite zu realisieren. Ein Anwendungsbeispiel für eine solche Signalübertragung stellt die Begrenzung von Überspannungen und Durchlassströmen auf zulässige Maximalwerte dar, die einerseits dem Eigenschutz des Leistungsbauelements dient und andererseits auch dem Schutz seiner peripheren Beschaltung. Die Begrenzung von Überspannungen und Durchlassströmen auf zulässige Maximalwerte wird in der Praxis häufig mit Hilfe von Sense- und Ansteuer- und Auswerteschaltungen realisiert, die vorteilhafterweise auf dem Chip des Leistungsbauelements integriert sein können. So könnte die Stromerfassung durch die Senseschaltung beispielsweise mit Hilfe eines Flächensegments des Leistungsbauelements inklusive Vorwiderstand erfolgen. Das erfasste Stromsignal wird mit Hilfe der Ansteuer- und Auswerteschaltung aufbereitet und ggf. weitergeleitet. Die Ansteuer- und Auswerteschaltung kann dann optional durch eine entsprechende Ansteuerung des Bauelementeneingangs den Strom auf zulässige Werte begrenzen.

Bei lateralen Leistungsbauelementen besteht oftmals das Problem, dass die Senseschaltung auf dem Potential der Hochspannungsseite liegt und die Ansteuer- und Auswerteschaltung auf dem Potential der Niederspannungsseite liegt, so dass also ein Signaltransfer zwischen der Hochspannungsseite und der Niederspannungsseite des Leistungsbauelements darzustellen ist. Dieser Signaltransfer sollte möglichst flächenneutral sein und die Sperrspannungsfestigkeit des Leistungsbauelements nicht herabsetzen.

Aus den Druckschriften Patent Abstracts of Japan vol. 2000, no. 04, 31. August 2000 & JE 2000 022175 A (Toshiba Corp), 21. Januar 2000 (2000-01 - 21) & US 6 150 702 A (Funaki et al.) 21. November 2000 (2000-11-21) und (EP-A-0 576 001 (Tokyo Shibaura Electric Co) 29. Dezember 1993 sind Halbleiter-Leistungsbauelemente bekannt, bei denen zwischen der Hochspannungsseite und der Niederspannungsseite spezielle Gebiete mit verringerter Feldstärke angeordnet sind, diese sind beispielsweise aus Silizium und dienen u.a. zur Spannungsübertragung von der Hochspannungs- auf die Niederspannungsseite. Die Gebiete bilden weiterhin einen Widerstand, der von den übrigen Bereichen des Leistungshalbleiters elektrisch isoliert ist.

### Vorteile der Erfindung

Zur Realisierung einer Signalübertragung von der Hochspannungsseite zur Niederspannungsseite eines Halbleiter-Leistungsbauelements der hier in Rede stehenden Art ist erfindungsgemäß mindestens ein Poly-Silizium-Widerstand vorgesehen, der die Hochspannungsseite mit der Niederspannungsseite verbindet. Dieser Poly-Silizium-Widerstand ist über dem RESURF-Gebiet angeordnet und von diesem elektrisch isoliert.

Erfindungsgemäß ist erkannt worden, dass für eine Signalübertragung von der Hochspannungsseite zur Niederspannungsseite eines Leistungsbauelements ein Element eingesetzt werden sollte, das einen linearen Spannungsabfall entlang seiner Längsausdehnung aufweist, um die optimale Feld- bzw. Potentialverteilung im RESURF-Gebiet nicht zu stören. Es wird daher die Verwendung eines ohmschen Widerstandes vorgeschlagen. Erfindungsgemäß ist ferner erkannt worden, dass im Durchlassfall des Leistungsbauelements hohe Stromdichten und Trägerdichten (Hochinjektion) vorliegen, so dass der Widerstand gegenüber Beeinflussungen infolge dieses Stromflusses isoliert sein muss. Erfindungsgemäß ist schließlich erkannt worden, dass diese Anforderungen sehr gut von einem Poly-Silizium-Widerstand erfüllt werden, der das RESURF-Gebiet überquert und von diesem elektrisch isoliert ist.

Über den erfindungsgemäß vorgeschlagenen Poly-Silizium-Widerstand ist also gleichzeitig die Übertragung von Messsignalen und im Zusammenspiel mit dem unter ihm angeordneten RESURF-Gebiet die Darstellung einer hohen Sperrspannungsfestigkeit bei minimalem Platzbedarf möglich. Im Gegensatz dazu wäre eine Signalübertragung über einen diffundierten Widerstand im Durchlassfall eines bipolaren Leistungsbauelements unmöglich, da die Signalübertragung durch die üblicherweise vorliegende Hochinjektion gestört würde. Wie bereits erwähnt, ist eine solche Beeinflussung im Falle des erfindungsgemäß vorgeschlagenen Poly-Silizium-Widerstandes ausgeschlossen, da er vollständig vom Halbleiter isoliert ist.

Um bei hoher Sperrspannung von mehreren Hundert Volt den Leckstrom klein zu halten, muss der Poly-Silizium-Widerstand groß sein, d. h. größer als einige kQ. Er sollte dementsprechend also möglichst lang sein. Diese Länge läßt sich in vorteilhafterweise platzsparend realisieren, indem der Poly-Silizium-Widerstand das RESURF-Gebiet nicht auf dem kürzesten Wege, sondern mäanderförmig überquert. Der Poly-Silizium-Widerstand könnte dazu beispielsweise als spiralförmiger Mäander von der Hochspannungsseite zur Niederspannungsseite geführt sein oder auch in Form eines Zickzack-Mäanders.

Es erweist sich, den Poly-Silizium-Widerstand durch ein Feldoxid vom RESURF-Gebiet bzw. Halbleiter zu isolieren. Denkbar wäre aber auch der Einsatz von anderen elektrisch isolierenden Materialien.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Ansprüche und andererseits auf die nachfolgende Erläuterung mehrerer Ausführungsbeispiele der Erfindung anhand der Zeichnungen zu verweisen.

### Zeichnungen

- Fig. 1: zeigt die Draufsicht auf ein erfindungsgemäßes Leistungsbauelement mit RESURF-Gebiet und vier Poly-Silizium-Widerständen.
- Fig. 2: zeigt die Draufsicht auf ein weiteres erfindungsgemäßes Leistungsbauelement mit zwei zickzack-mäanderförmigen Poly-Silizium-Widerständen.
- Fig. 3: zeigt einen Querschnitt entlang der in Fig. 1 eingezeichneten Schnittachse AA' für einen lateralen pnp-Transistor.
- Fig. 4: zeigt einen Querschnitt entlang der in Fig. 1 eingezeichneten Schnittachse AA' für eine laterale Diode.
- Fig. 5: zeigt einen Querschnitt entlang der in Fig. 1 eingezeichneten Schnittachse AA' für einen LDMOS.
- Fig. 6: zeigt einen Querschnitt entlang der in Fig. 1 eingezeichneten Schnittachse AA' für einen LIGBT.
- Fig. 7: zeigt einen der Fig. 6 entsprechenden Querschnitt durch einen Lateral-Vertikal-IGBT (LVIGBT), wobei zusätzlich auch die Verschaltung der Senseschaltung und der Ansteuer- und Auswerteschaltung dargestellt ist.
- Fig. 8: zeigt die in Fig. 7 dargestellte Situation als Schaltskizze.
- Fig. 9: zeigt die Schaltskizze eines weiteren LVIGBT mit Senseschaltung und Ansteuer- und Auswerteschaltung.
- Fig. 10: zeigt die Draufsicht eines Ausführungsbeispiels für den Anschluss von Poly-Silizium-Widerständen an die Senseschaltung und die Ansteuer- und Auswerteschaltung für den in Fig. 9 dargestellten LVIGBT.
- Fig. 11: zeigt die Draufsicht eines weiteren Ausführungsbeispiels für den Anschluss von Poly-Silizium-Widerständen an die Senseschaltung und die Ansteuer- und Auswerteschaltung für den in Fig. 9 dargestellten LVIGBT.
- Fig. 12: zeigt eine vergrößerte Draufsicht auf den in Fig.10 dargestellten Bereich des Widerstandes 16.
- Fig. 13: zeigt einen Querschnitt durch den in Fig. 12 dargestellten Bereich entlang des Schnittes BB'.
- Fig. 14: zeigt eine Draufsicht auf die Kathodenseite eines LVIGBT ohne Metallisierung und Zwischendielektrikum.
- Fig. 15: zeigt eine Draufsicht auf die Kathodenseite eines LVIGBT mit Metall.
- Fig. 16: zeigt einen Querschnitt entlang der in Fig. 15 eingezeichneten Schnittachse CC'.
- Fig. 17: zeigt einen Querschnitt entlang der in Fig. 15 eingezeichneten Schnittachse DD'.
- Fig. 18: zeigt eine Draufsicht auf die Kathodenseite eines LVIGBT mit Metallisierung und Zwischendielektrikum.
- Fig. 19: zeigt einen Querschnitt entlang der in Fig. 18 eingezeichneten Schnittachse EE'.
- Fig. 20: zeigt einen Querschnitt entlang der in Fig. 18 eingezeichneten Schnittachse FF'.

### Beschreibung der Ausführungsbeispiele

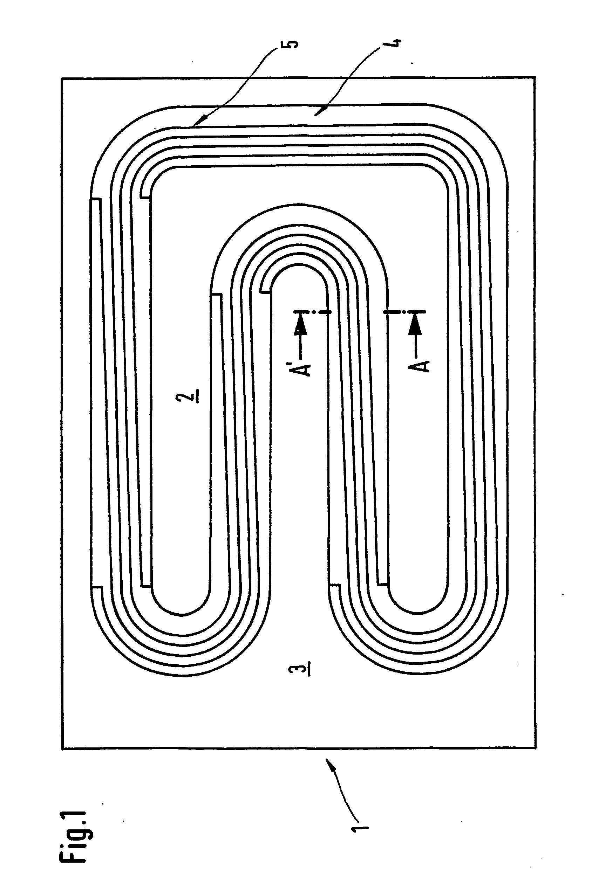

Wie bereits erwähnt, ist in Fig. 1 die Draufsicht auf ein erfindungsgemäßes Halbleiter-Leistungsbauelement 1 dargestellt mit einem zwischen Hochspannungsseite 2 und Niederspannungsseite 3 angeordneten RESURF-Gebiet 4. Die Hochspannungsseite 2 und die Niederspannungsseite 3 des hier dargestellten Leistungsbauelements 1 greifen fingerförmig ineinander und sind durch das RESURF-Gebiet 4 voneinander getrennt. An dieser Stelle sei noch angemerkt, dass es sich bei dem dargestellten Leistungsbauelement 1 beispielsweise um eine Diode, einen LIGBT, einen LDMOS oder auch um einen Bipolar-Transistor handeln könnte.

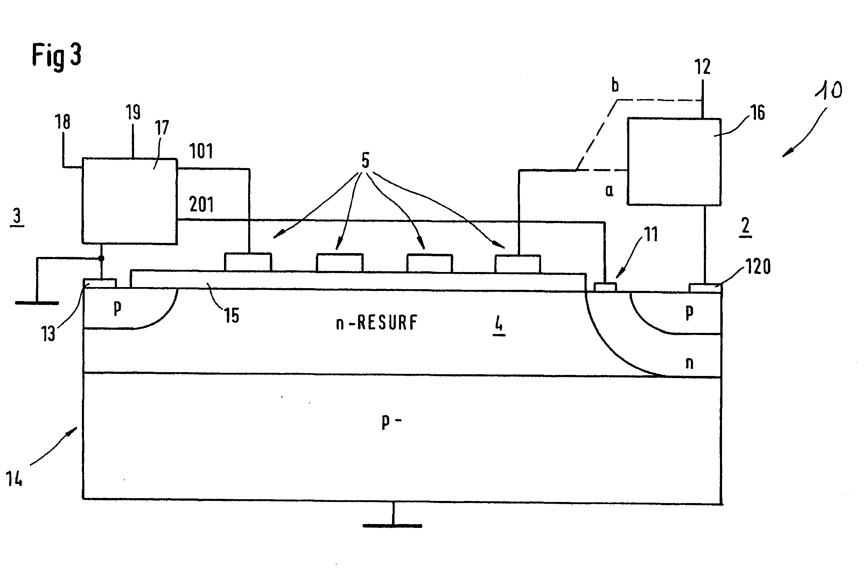

Erfindungsgemäß ist ein Poly-Silizium-Widerstand 5 - hier sogar vier Poly-Silizium-Widerstände 5 - über dem RESURF-Gebiet 4 angeordnet. Im hier dargestellten Ausführungsbeispiel sind die Poly-Silizium-Widerstände 5 mäanderförmig innerhalb der Fingerstruktur des RESURF-Gebiets 4 von der Hochspannungsseite 2 zur Niederspannungsseite 3 geführt. Die Poly-Silizium-Widerstände 5 sind von dem RESURF-Gebiet 4 elektrisch isoliert, was durch die Figuren 3 bis 6 verdeutlicht wird.

Im hier dargestellten Ausführungsbeispiel gehen die vier Poly-Silizium-Widerstände 5 in gleichen Abständen nacheinander von der Hochspannungsseite 2 aus und münden in der Niederspannungsseite 3. Von Vorteil ist es, wenn die Poly-Silizium-Widerstände 5 die im Hinblick auf den Herstellungsprozess minimal mögliche Breite und den minimal möglichen Abstand voneinander bzw. von Windung zu Windung aufweisen und die Hochspannungsseite 2 so oft umlaufen, wie es auf der Basis der eben genannten Designregeln möglich ist.

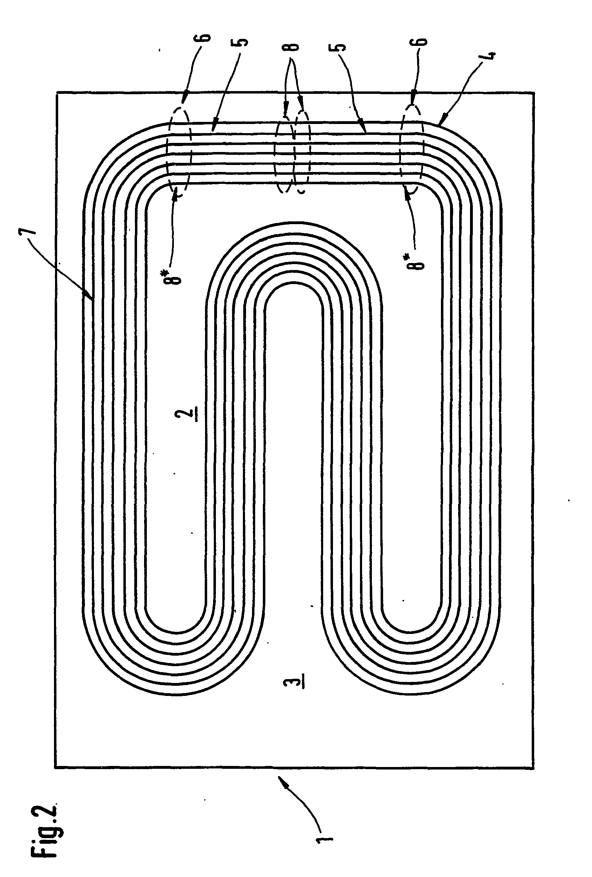

Eine weitere Möglichkeit der Anordnung von Poly-Silizium-Widerständen 5 auf dem RESURF-Gebiet 4 eines Leistungsbauelements 1 ist in Fig. 2 dargestellt. Hier sind zwei Poly-Silizium-Widerstände 5 jeweils in Form eines Zickzack-Mäanders ausgeführt, deren Enden 8 sich auf der Niederspannungsseite 3 befinden und deren Anfänge 8* auf der Hochspannungsseite 2 liegen. Über diese zickzack-mäanderförmigen Poly-Silizium-Widerstände 5 ist ein Signaltransfer zwischen Hochspannungsseite 2 und Niederspannungsseite 3 möglich. Zum Erzielen einer hohen Sperrfähigkeit werden die äußeren Ecken 6 der Zickzack-Mäander jeweils an Poly-Silizium-Streifen 7 angeschlossen. Diese Poly-Silizium-Streifen 7 verlaufen auf Bahnen mit ungefähr konstantem Abstand von der Hochspannungsseite 2 bzw. der Niederspannungsseite 3, mäanderförmig entlang des RESURF-Gebietes 4. Durch diese Ausgestaltung werden Spitzen der elektrischen Feldstärke bzw. Feldüberhöhungen im Halbleiter unter den äußeren Ecken 6 der zickzack-mäanderförmigen Poly-Silizium-Widerstände 5 vermieden. Auf diese Weise wird einem Avalanche-Durchbruch des Bauelements schon bei kleinen Spannungen und damit einer Herabsetzung der Sperrfähigkeit vorgebeugt. Außerdem wird mit Hilfe der Poly-Silizium-Streifen 7 der Potentialverlauf über dem RESURF-Gebiet 4 stabilisiert, was auch zu einer Stabilitätserhöhung des Bauelements unter hoher Sperrspannung führt.

Feldüberhöhungen im Halbleiter unter den inneren Enden 8 der zickzack-mäanderförmigen Poly-Silizium-Widerstände 5 werden im vorliegenden Ausführungsbeispiel dadurch minimiert, dass diese inneren Enden 8 möglichst nahe zueinander angeordnet sind.

Für den Fall, dass nur ein einzelner Poly-Silizium-Widerstand benötigt wird, kommen prinzipiell zwei Ausgestaltungsmöglichkeiten in Fragen. In der ersten Variante wird der Poly-Silizium-Widerstand als einzelner Zickzack-Mäander ausgeführt, der zwei äußere Enden aufweist. Diese lassen sich in der beschriebenen Weise durch Poly-Silizium-Streifen abschließen. In der zweiten Variante besteht der Poly-Silizium-Widerstand aus einer Parallelschaltung der oben beschriebenen mehreren Zickzack-Mäander. Die Parallelschaltung erhält man durch jeweils paarweises Verbinden der ursprünglich benachbarten inneren Enden der mehreren Zickzack-Mäander.

Die in Verbindung mit Fig. 2 vorgeschlagenen Ausgestaltungen der erfindungsgemäßen Poly-Silizium-Widerstände haben gegenüber den in Verbindung mit Fig. 1 vorgeschlagenen Formen den Vorteil einer einfachen, d.h. zeitsparenden, Umsetzung im Layout. Demgegenüber lassen sich mit den in Verbindung mit Fig. 1 beschriebenen Ausgestaltungen höherohmige Widerstände realisieren.

Der in Fig. 3 im Querschnitt dargestellte laterale pnp-Transistor 10 weist die Anschlüsse BASIS 11, EMITTER 120 und KOLLEKTOR 13 auf. Ein derartiger Transistor kann beliebig viele Finger umfassen und auf p⁻ - Substrat, p⁻ / p⁺ - Substrat oder SOI-Substrat hergestellt sein. Im Detail dargestellt ist hier die Variante auf p⁻- Substrat 14. In jedem dieser Fälle ist das RESURF-Gebiet 4 dann n-dotiert. Der über dem RESURF-Gebiet 4 angeordnete Poly-Silizium-Widerstand 5 ist durch eine Feldoxidschicht 15 gegen das RESURF-Gebiet 4 elektrisch isoliert.

Im hier dargestellten Ausführungsbeispiel dient der Poly-Silizium-Widerstand 5 zur Signalübertragung zwischen einer auf dem Potential der Hochspannungsseite 2 liegenden Senseschaltung 16 und einer auf dem Potential der Niederspannungsseite 3 liegenden Ansteuer- und Auswerteschaltung 17. Der Poly-Silizium-Widerstand 5 wird auf der Hochspannungsseite 2, nämlich der Emitterseite, mit einem Spannungssignal in der Größenordnung der Emitterspannung beaufschlagt, wozu er alternativ direkt mit dem externen Emitteranschluß 12 der Senseschaltung 16 verbunden werden kann, was durch die Leitungsführung b angedeutet ist, oder mit der Senseschaltung 16, was durch die Leitungsführung a angedeutet ist. Die Niederspannungsseite, d. h. die kollektornahe Seite, des Poly-Silizium-Widerstandes 5 ist über einen Signalerfassungseingang 101 mit der Ansteuer- und Auswerteschaltung 17 verbunden.

Die Ansteuer- und Auswerteschaltung 17 weist ferner einen optionalen Statusausgang 18 und einen Ansteuereingang 19 auf. Der hier dargestellte Bipolartransistor 10 läßt sich über den Ansteuereingang 19 von einer externen Signalquelle ansteuern. Der Basisanschluss 11 kann direkt von der Ansteuer- und Auswerteschaltung 17 angesteuert werden. Dazu umfasst die Ansteuer- und Auswerteschaltung 17 einen Ansteuerausgang 201 mit einem hochspannungsfesten Schaltelement. Dabei kann es sich beispielsweise um einen npn- bzw. NMOS-Transistor handeln, dessen Emitter bzw. Source mit Massepotential und dessen Kollektor bzw. Drain mit dem Basisanschluss 11 verbunden ist.

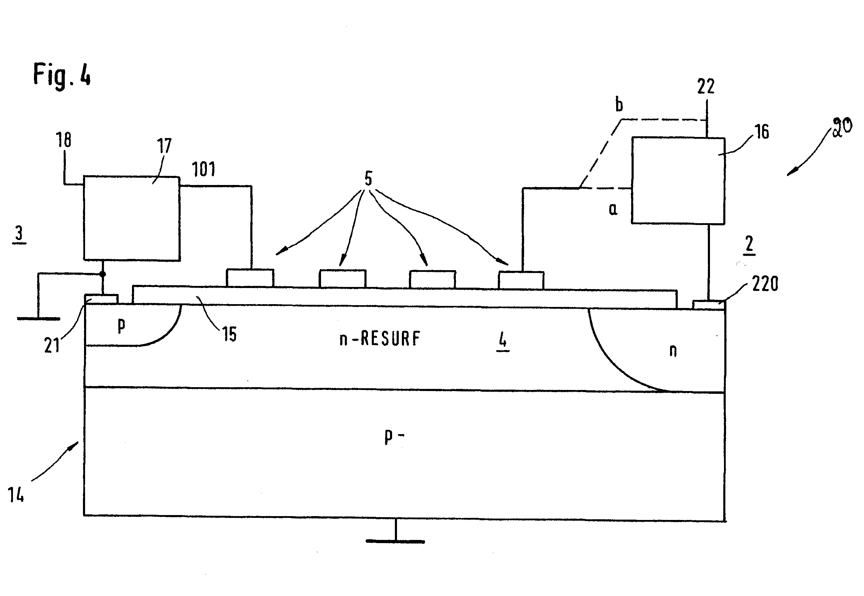

Fig. 4 zeigt einen zu Fig. 3 analogen Querschnitt durch eine laterale Diode 20 mit den Anschlüssen ANODE 21 und KATHODE 220. Die Diode 20 kann beliebig viele Finger aufweisen und genau wie der in Fig. 3 dargestellte pnp-Transistor auf p⁻- Substrat, p⁻/p⁺- Substrat oder auf SOI-Substrat hergestellt sein. Im Detail dargestellt ist hier die Variante auf p⁻ - Substrat 14. In diesen drei Fällen weist das RESURF-Gebiet 4 immer eine n-Dotierung auf. Der Poly-Silizium-Widerstand 5 ist wieder durch eine Feldoxidschicht 15 gegen das Halbleitersubstrat 14 elektrisch isoliert. Außerdem dient der Poly-Silizium-Widerstand 5 auch hier wieder zur Signalübertragung zwischen einer auf dem Potential der Hochspannungsseite 2 liegenden Senseschaltung 16 und einer auf dem Potential der Niederspannungsseite 3 liegenden Ansteuer- und Auswerteschaltung 17. Die Senseschaltung 16 weist einen externen Kathodenanschluss 22 zum Anschluss einer Last auf. Auf der Hochspannungsseite 2 kann der Poly-Silizium-Widerstand 5 alternativ direkt mit diesem externen Kathodenanschluss 22 verbunden sein, was durch die Leitungsführung b angedeutet ist, oder mit der Senseschaltung 16, was durch die Leitungsführung a angedeutet ist. Die Ansteuer- und Auswerteschaltung 17 weist einen Statuseingang 18 auf und einen Signalerfassungseingang 101, über den der Poly-Silizium-Widerstand 5 an die Ansteuer- und Auswerteschaltung 17 angeschlossen ist.

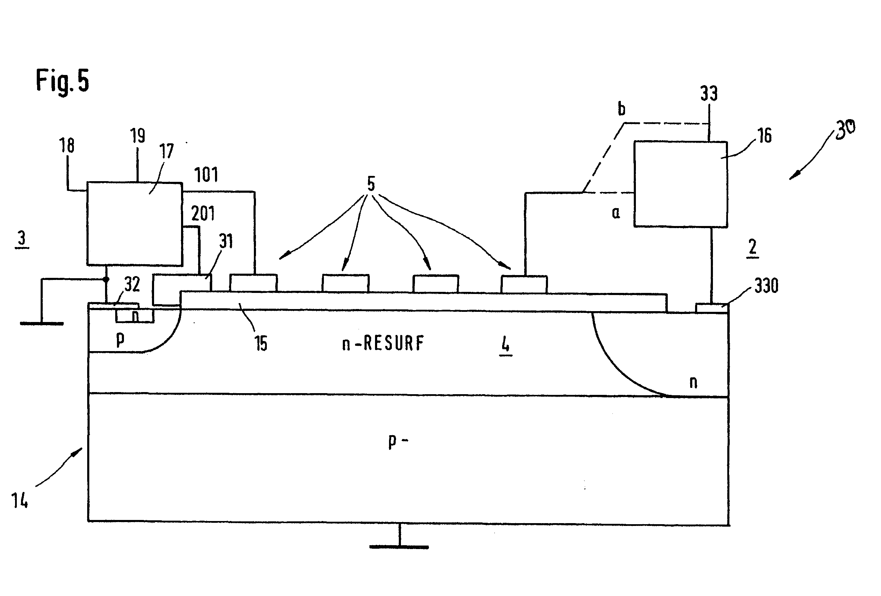

Fig. 5 zeigt eine zu den Figuren 3 und 4 analoge Querschnittsdarstellung eines LDMOS 30 mit den Anschlüssen GATE 31, SOURCE 32 und DRAIN 330. Auch ein derartiger LDMOS kann beliebig viele Finger aufweisen und wie die voranstehend beschriebenen Bauelemente auf p⁻ - Substrat, p⁻/p⁺ - Substrat oder SOI-Substrat hergestellt sein. Im Detail dargestellt ist hier die Variante auf p⁻ - Substrat 14. Der Poly-Silizium-Widerstand 5, der auch hier zur Signalübertragung zwischen einer auf dem Potential der Hochspannungsseite 2 liegenden Senseschaltung 16 und einer auf dem Potential der Niederspannungsseite 3 liegenden Ansteuer- und Auswerteschaltung 17 dient, ist durch eine Feldoxidschicht 15 gegen das Halbleitersubstrat 14 elektrisch isoliert. Er kann hochspannungsseitig alternativ direkt mit dem externen Drainanschluss 33 (Leitungsführung b) oder mit der Senseschaltung 16 (Leitungsführung a) verbunden sein. Niederspannungsseitig ist der Poly-Silizium-Widerstand 5 an einen Signalerfassungseingang 101 der Ansteuer- und Auswerteschaltung 17 angeschlossen. Die Ansteuer- und Auswerteschaltung 17 weist außerdem einen optionalen Statusausgang 18 und einen Ansteuereingang 19 auf, über den der LDMOS 30 von einer externen Signalquelle aus ansteuerbar ist. Dazu umfasst die Ansteuer- und Auswerteschaltung 17 einen Ansteuerausgang 201, der mit dem GATE 31 verbunden ist.

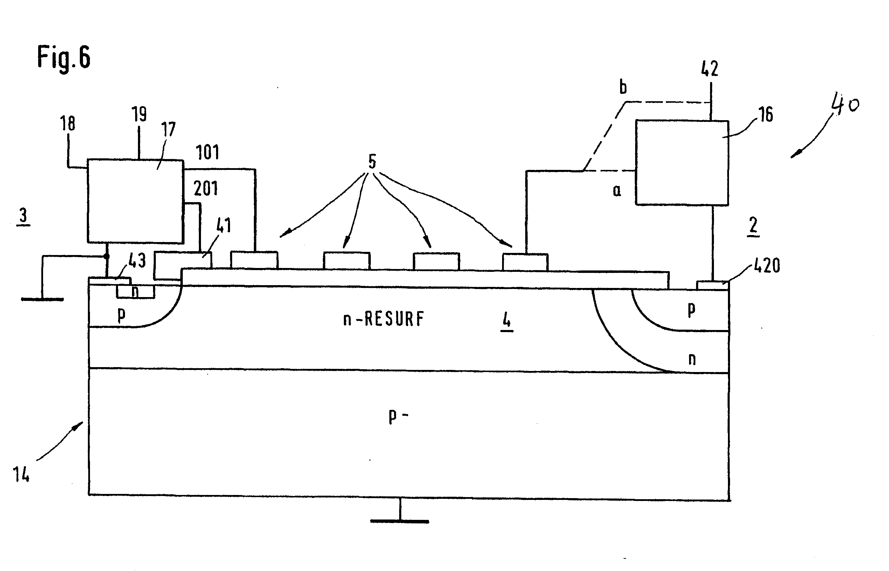

Fig. 6 zeigt einen zu den Figuren 3 bis 5 analogen Querschnitt durch einen LIGBT 40 mit den Anschlüssen GATE 41, ANODE 420 und Kathode 43. Auch ein solcher LIGBT kann beliebig viele Finger aufweisen und auf p⁻ - Substrat, p/p⁺ - Substrat oder SOI-Substrat hergestellt sein, wobei das RESURF-Gebiet 4 immer eine n-Dotierung aufweist. Im Detail dargestellt ist hier die Variante auf p⁻ - Substrat 14. Wieder ist der Poly-Silizium-Widerstand 5 durch eine Feldoxidschicht 15 gegen das Halbleitersubstrat 14 elektrisch isoliert. Er dient auch hier zur Signalübertragung zwischen einer hochspannungsseitig angeordneten Senseschaltung 16 und einer niederspannungsseitig angeordneten Ansteuer- und Auswerteschaltung 17. Im vorliegenden Ausführungsbeispiel kann der Poly-Silizium-Widerstand 5 alternativ direkt mit dem externen Anodenanschluss 42 (Leitungsführung b) oder mit der Senseschaltung 16 (Leitungsführung a) verbunden sein. Niederspannungsseitig ist der Poly-Silizium-Widerstand 5 an einen Signalerfassungseingang 101 der Ansteuer- und Auswerteschaltung 17 angeschlossen. Die Ansteuer- und Auswerteschaltung 17 weist außerdem einen optionalen Statusausgang 18 und einen Ansteuereingang 19 auf, über den der LIGBT 40 von einer externen Signalquelle aus ansteuerbar ist. Dazu umfasst die Ansteuer- und Auswerteschaltung 17 einen Ansteuerausgang 201, der mit dem GATE 41 verbunden ist, so dass die Ansteuer- und Auswerteschaltung 17 wahlweise regelnd auf das GATE 41 einwirken kann.

Selbstverständlich sind alle in Verbindung mit den Figuren 3 bis 6 erwähnten Dotierungen vertauschbar - p gegen n -, wobei die gezeichneten Anschlüsse und Potentiale dann sinngemäß zu ändern sind.

Die Senseschaltung 16 und die Ansteuer- und Auswerteschaltung 17 könnten beispielsweise zur Erfassung und Begrenzung der Anodenspannung des LIGBT eingesetzt werden. Für die nachfolgende Erläuterung ist die Signalführung b gewählt worden, so dass die Senseschaltung 16 durch eine leitende Verbindung ersetzt werden kann. An den externen Anodenanschluss 42 sei eine induktive Last angeschlossen, durch die ein Strom fließt; der LIGBT sei eingeschaltet. Wird der LIGBT nun aufgrund eines Steuersignals am Ansteuereingang 19 ausgeschaltet, wozu der Ansteuerausgang 201 der Ansteuer- und Auswerteschaltung 17 seine Spannung auf Werte unterhalb der Schwellspannung des LIGBTs reduziert, so steigt die Spannung am Anodenanschluss 420 bzw. 42 an. Dieser Anstieg würde ohne weitere Maßnahmen so hohe Anodenspannungen erzeugen, dass das Halbleiterbauelement seine Durchbruchspannung erreicht.

Um einen unkontrollierten Anstieg der Anodenspannung zu verhindern, wird der Spannungsanstieg am Anodenanschluss 420 bzw. 42 über den mäanderförmigen Poly-Silizium-Widerstand 5 als Strom- oder Spannungssignal auf die Niederspannungsseite 3 übertragen und dem Signalerfassungseingang 101 der Ansteuer- und Auswerteschaltung 17 zugeführt. Die Ansteuer- und Auswerteschaltung 17 vergleicht dieses Signal mit einem Referenzwert, bei dessen Erreichen das Gate 41 über den Ansteuerausgang 201 derart ausgesteuert wird, dass die Anodenspannung auf einen vorgegebenen Wert begrenzt wird.

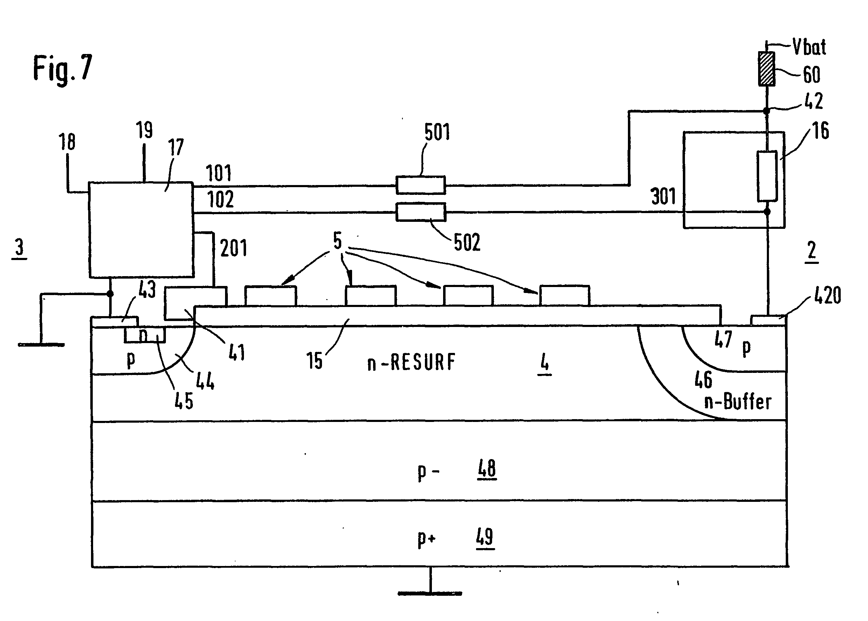

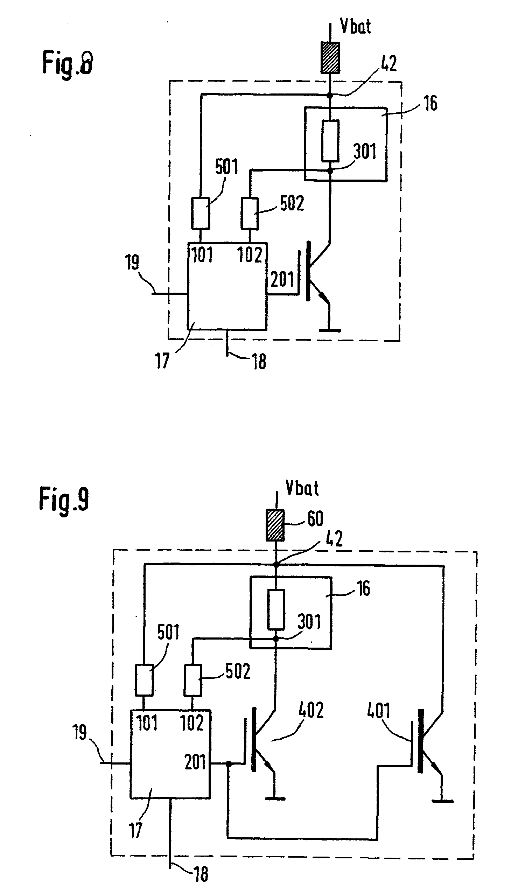

In Verbindung mit den Figuren 7 und 8 wird nachfolgend ein Lateral-Vertikal-IGBT (LVIGBT) mit Strombegrenzung und Stromstatusausgabe beschrieben, um ein weiteres Ausführungsbeispiel für eine Senseschaltung und eine Ansteuer- und Auswerteschaltung zu geben.

Der in Fig. 7 dargestellte LVIGBT ist auf einem p⁻ / p⁺ - Substrat hergestellt weist aber ansonsten den gleichen Aufbau auf, wie der in Fig. 6 dargestellte LIGBT, so dass gleiche Bezugszeichen in den Figuren 6 und 7 auch gleiche Elemente und Schaltungskomponenten bezeichnen. Der externe Anodenanschluss 42 des LVIGBT ist hier mit einer induktiven Last 60 verbunden, die über eine Betriebsspannungsquelle Vbat gespeist wird. Als Senseschaltung 16 dient im hier dargestellten Ausführungsbeispiel ein Widerstand 16, der z.B. in Form eines Poly-Silizium-Widerstandes realisiert sein kann. Wird der Ansteuer- und Auswerteschaltung 17 über den Ansteuereingang 19 eine Ansteuerspannung zugeführt, dann nimmt der Ansteuerausgang 201 und damit Gate 41 eine positive Spannung an; der LVIGBT wird eingeschaltet: An der Oberfläche des Halbleiters unter dem Gate 41, insbesondere im p-Gebiet 44 wird ein Inversionskanal erzeugt, woraufhin Elektronen vom n-Gebiet 45 in das Resurf-Gebiet 4 injiziert werden. Darauf antwortet die p-Anode 47 mit einer Löcherinjektion. In der Folge werden das Resurf-Gebiet 4 und große Teile des p⁻-Gebietes 48 von Ladungsträgern überschwemmt und geraten in den Zustand der Hochinjektion. Es fließt jetzt ein Strom von Vbat durch die Last 60, den Widerstand 16, über die Anodenmetallisierung 420, die p-Anode 47 und den n-Buffer 46. Ein Teil des Stromes fließt über das p⁻-Gebiet 48 und das p⁺-Gebiet 49 zur Masse auf der Rückseite des Bauelements ab, der andere Teil fließt über das Resurf-Gebiet 4 lateral über das p-Gebiet 44 und das n-Gebiet 45 zur Kathode 43, die ihrerseits mit Masse verbunden ist. Infolge der induktiven Last 60 erreicht der Strom nicht sofort seinen statischen Endwert, sondern steigt von Null in einer Steilheit an, die von der Höhe von Vbat, der Größe der Induktivität der Last 60 und dem Spannungsabfall zwischen dem externen Anodenanschluss 42 und der Kathode 43 des LVIBGT abhängt. Dieser Stromanstieg verursacht einen dem Strom proportionalen Spannungsabfall über dem Widerstand 16, der sich wie nachfolgend erläutert ermitteln läßt.

Wie in den Figuren 7 und 8 gezeigt, wird die am Widerstand 16 anliegende Spannung am externen Anodenanschluss 42 und einer mit 301 bezeichneten Stelle abgegriffen und den Signalerfassungseingängen 101 und 102 der Ansteuer- und Auswerteschaltung 17 zugeführt. Der Spannungsabgriff erfolgt mit je einem Mäander 501 und 502 des Poly-Silizium-Widerstandes 5. Die Ansteuer- und Auswerteschaltung 17 bildet die Differenz der an den Signalerfassungseingängen 101 und 102 anliegende Signale und ermittelt somit eine dem Strom proportionale Spannung. Die so ermittelte Spannung wird in der Ansteuer- und Auswerteschaltung 17 mit zwei Referenzspannungen verglichen. Erreicht die dem Strom proportionale ermittelte Spannung den Wert der einen Referenzspannung, so wird am Statusausgang 18 der Ansteuer- und Auswerteschaltung ein Statussignal erzeugt. Erreicht die ermittelte Spannung den Wert der anderen Referenzspannung, so reduziert die Ansteuer- und Auswerteschaltung 17 den Betrag des Gatesteuersignals am Ansteuerausgang 201 soweit, dass ein weiterer Stromanstieg durch die Last 60 verhindert wird. Der hier dargestellte Leistungsschalter schützt somit sich selbst und die Last 60 vor Überströmen.

In Fig. 7 sind die beiden Mäander 501 und 502 des Poly-Silizium-Widerstandes 5 in ihrer elektrischen Verschaltung als 501 und 502 dargestellt. Im Querschnittsbild des LVIGBT sind sie ferner in ihrer prinzipiellen Lage angedeutet und als 5 gekennzeichnet. In Fig. 8 ist eine Schaltskizze des eben beschriebenen LVIGBT mit Strombegrenzung dargestellt. Die mit der gestrichelten Linie umrandeten Strukturen sind auf einem Chip integriert.

In einer vorteilhaften Ausführungsform, die als Schaltskizze in Fig. 9 dargestellt ist, ist lediglich ein kleiner Teil 402 des LVIGBT über den Widerstand 16 mit der Last 60 verbunden. Dieser kleine Teil 402 wird dann quasi als Sensezelle verwendet. Der größte Teil 401 des LVIGBT ist direkt mit der Last 60 verbunden. Der Vorteil dieser Anordnung gegenüber der in Fig. 8 dargestellten Variante ist ein geringerer Spannungsabfall über dem Leistungsbauelement, da nur ein Teil des Laststromes durch den Widerstand 16 fließt.

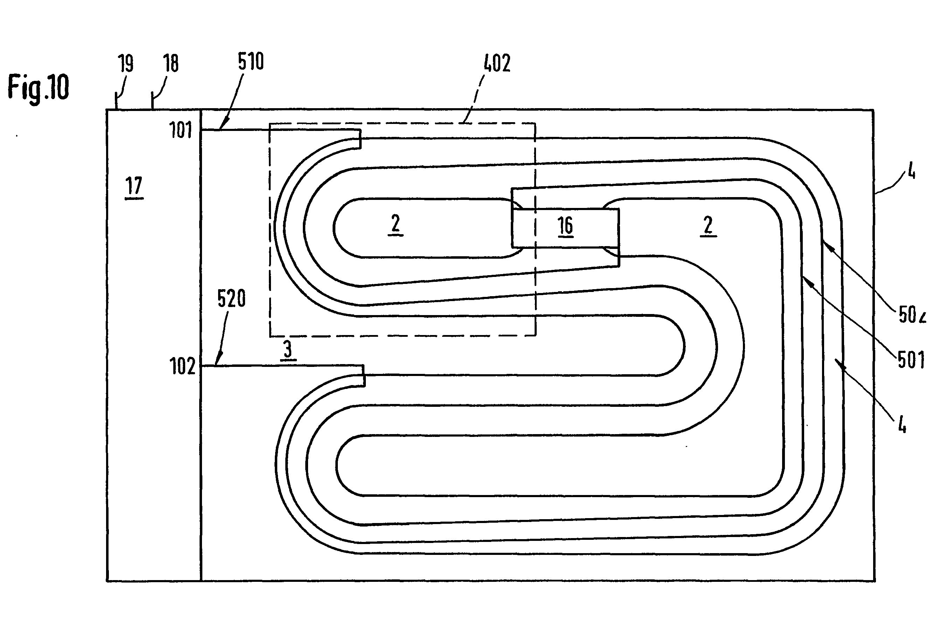

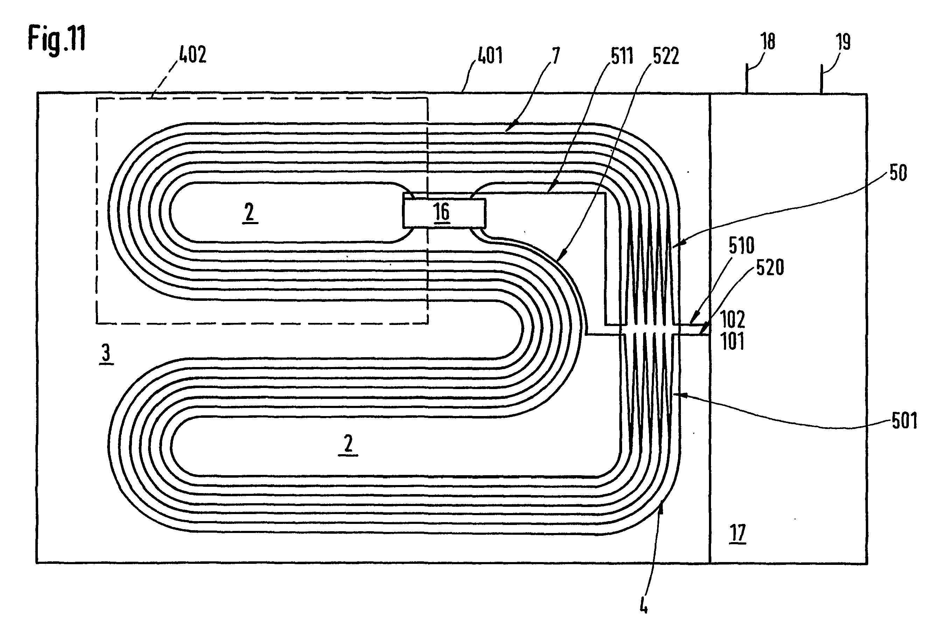

Bei den Figuren 10 und 11 handelt es sich um schematische Draufsichten, die verschiedene Realisierungsmöglichkeiten für den Spannungsabgriff über dem Widerstand 16 für den in Fig. 9 dargestellten LVIGBT zeigen. Die in Fig. 10 dargestellte Variante umfasst zwei Poly-Silizium-Mäander 501 und 502, die direkt an den Widerstand 16 geführt sind. Der Widerstand 16 besteht hier ebenfalls aus Poly-Silizium. Die dem Widerstand 16 abgewandten Enden der Poly-Silizium-Mäander 501 und 502 sind über Metallzuleitungen 510 und 520 an die Signalerfassungseingänge 101 und 102 der Ansteuer- und Auswerteschaltung angeschlossen. Alle anderen Bezugszeichen entsprechen denen in Fig. 9. Die in Fig. 11 dargestellte Variante umfasst zwei Poly-Silizium-Zickzack-Mäander 501 und 502, die über Metallzuleitungen 511 und 522 an den Widerstand 16 geführt sind. Die dem Widerstand 16 abgewandten Enden der Poly-Silizium-Zickzack-Mäander 501 und 502 sind ebenfalls über Metallzuleitungen 510 und 520 an die Signalerfassungseingänge 101 und 102 der Ansteuer- und Auswerteschaltung angeschlossen. Alle anderen Bezugszeichen entsprechen denen in Fig. 9.

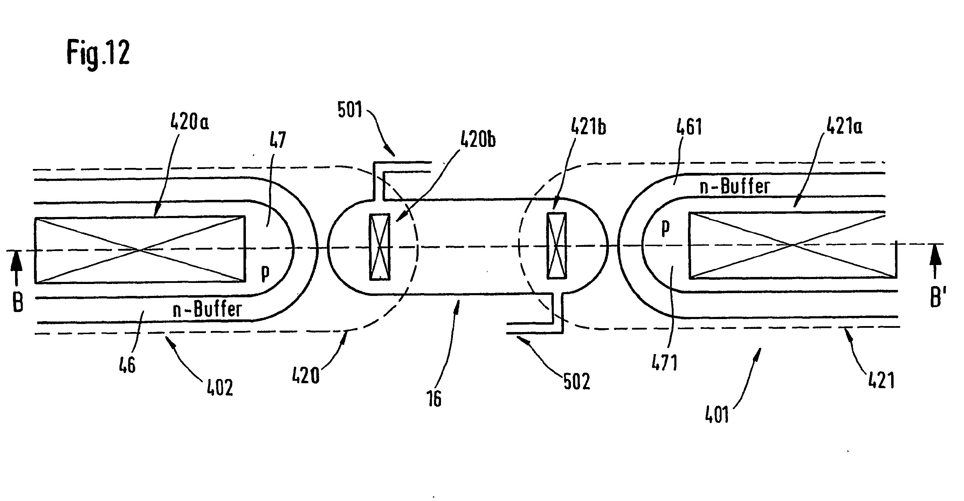

Wie bereits erwähnt zeigen die Figuren 10 und 11 eine genauere Darstellung der Anschlussführung der Poly-Silizium-Mäander 501 und 502 an die Senseschaltung 16 und an die Ansteuer- und Auswerteschaltung 17. Der in Fig. 10 dargestellte Bereich um den Widerstand 16 mit den Anschlussstellen der Poly-Silizium-Mäander 501 und 502 ist in Fig. 12 nochmals vergrößert in Draufsicht dargestellt.

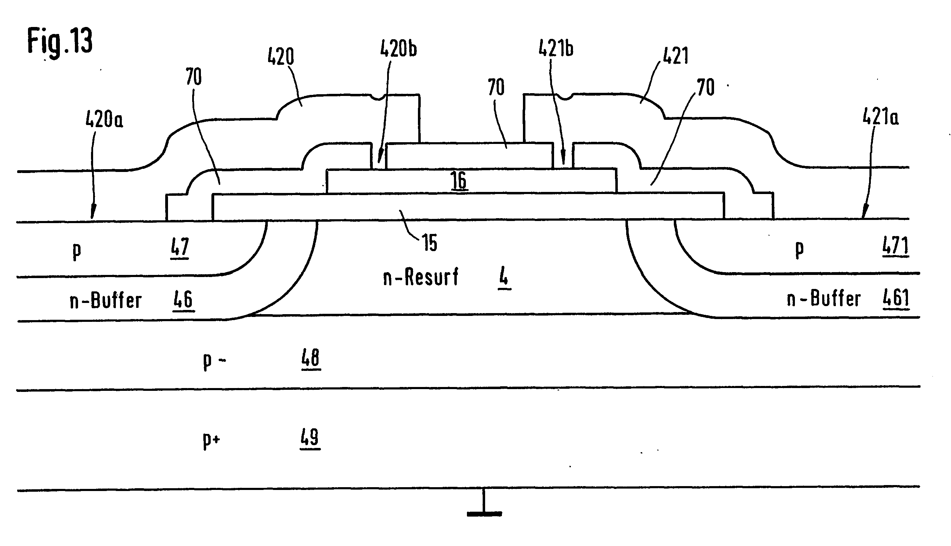

Die Anodenmetallisierungen 420 und 421, die die Anodendiffusionen der beiden LVIGBT-Teile 401 und 402 und Teile des Widerstandes 16 überdecken, sind gestrichelt angedeutet. Die Anodenmetallisierung 420 kontaktiert im Bereich 420a die p-Anodendiffusion 47 des LVGBT-Teils 402 und im Bereich 420b den Widerstand 16. Entsprechend kontaktiert die Anodenmetallisierung 421 im Bereich 421 a die p-Anodendiffusion 471 des LVGBT-Teils 401 und im Bereich 421 b den Widerstand 16. Die p-Anodendiffusionen 47 und 471 sind jeweils in einen n-Buffer 46 bzw. 461 eingebettet. Eine die Poly-Silizium-Mäander 501 und 502 gegen das RESURF-Gebiet elektrisch isolierende Feldoxidschicht und eine die Metallisierungen und das Poly-Silizium voneinander isolierende Zwischenoxidschicht sind aus Gründen der Übersichtlichkeit zwar nicht in Fig. 12 dargestellt, aber in Fig.13, die einen Querschnitt entlang des Schnittes BB' in Fig. 12 wiedergibt. Weder in Fig. 12 noch in Fig 13 sind die nach dem Stand der Technik üblichen, über den Metallisierungen liegenden Passivierungsschichten dargestellt. Fig. 12 verdeutlicht, dass die Poly-Silizium-Mäander 501 und 502 im hier dargestellten Fall direkt an den Poly-Silizium-Widerstand 16 angesetzt sind.

An den Stellen, an denen ein über dem Resurf-Gebiet 4 angeordneter Poly-Silizium-Mäander endet und die Signalweiterführung mittels Metallzuleitungen durchgeführt wird, ist eine besondere Konstruktion nötig, um die Sperrfähigkeit des Bauelements nicht deutlich zu reduzieren.

Am Beispiel der Kathodenseite des in Fig. 7 dargestellten LVIGBT werden nachfolgend zwei Ausführungsbeispiele für derartige Konstruktionen erläutert.

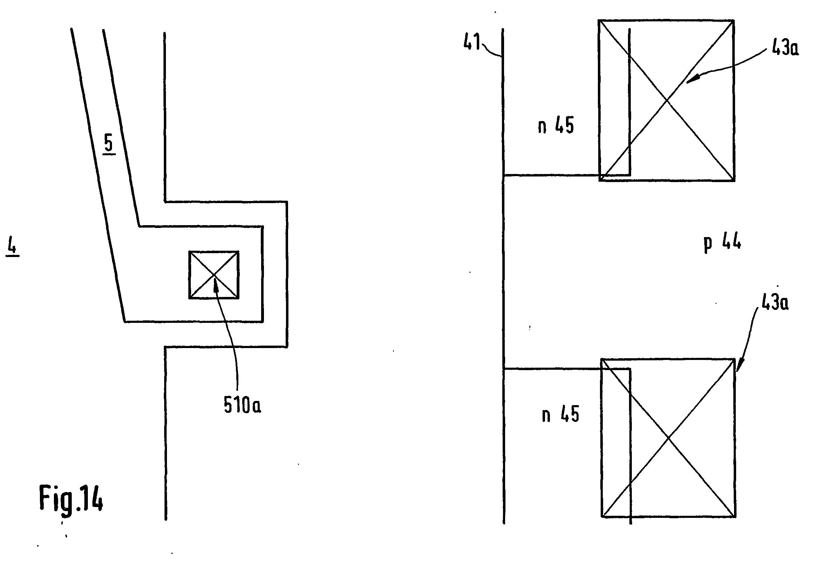

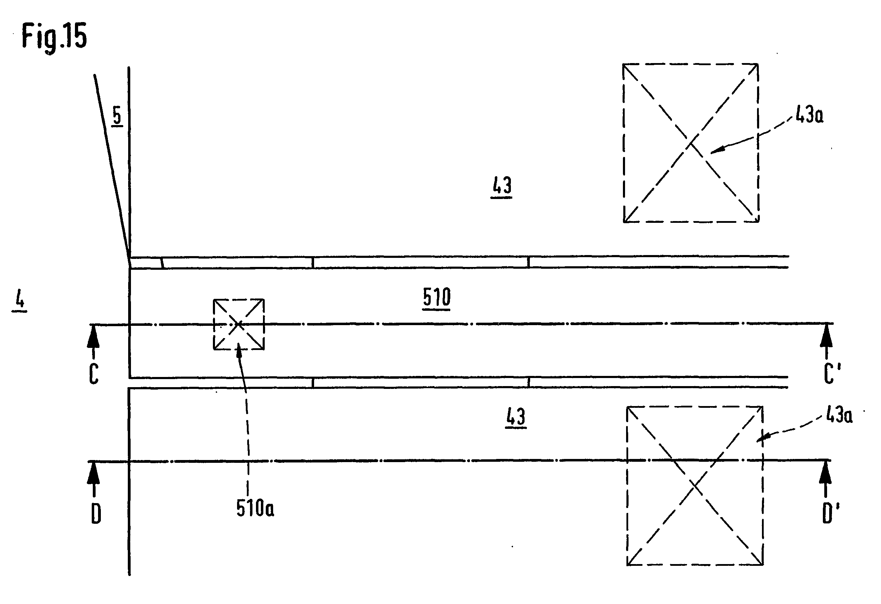

In Fig. 14 ist in Draufsicht eine erste Realisierungsmöglichkeit ohne Metallisierung und Zwischendielektrikum dargestellt; eine Draufsicht mit Metallisierung zeigt Fig. 15. Das Ende des Poly-Silizium-Mäanders 5 wird so von der Metallzuleitung 510 kontaktiert, dass diese auf der dem Hochspannungsgebiet zugewandten Seite eine Flucht mit der Kathodenmetallisierung 43 bildet; außerdem werden alle spitzen Ecken im Polysilizium von der Metallisierung verdeckt. Beide Maßnahmen halten Feldspitzen klein, die zu einer Reduktion der Durchbruchspannung des Bauelements führen können. Mit 510a ist der Bereich der Metallzuleitung 510 bezeichnet, der den Poly-Silizium-Mäander 5 kontaktiert. Mit 43a sind die Bereiche der Kathodenmetallisierung 43 bezeichnet, die die Silizium-Oberfläche kontaktieren.

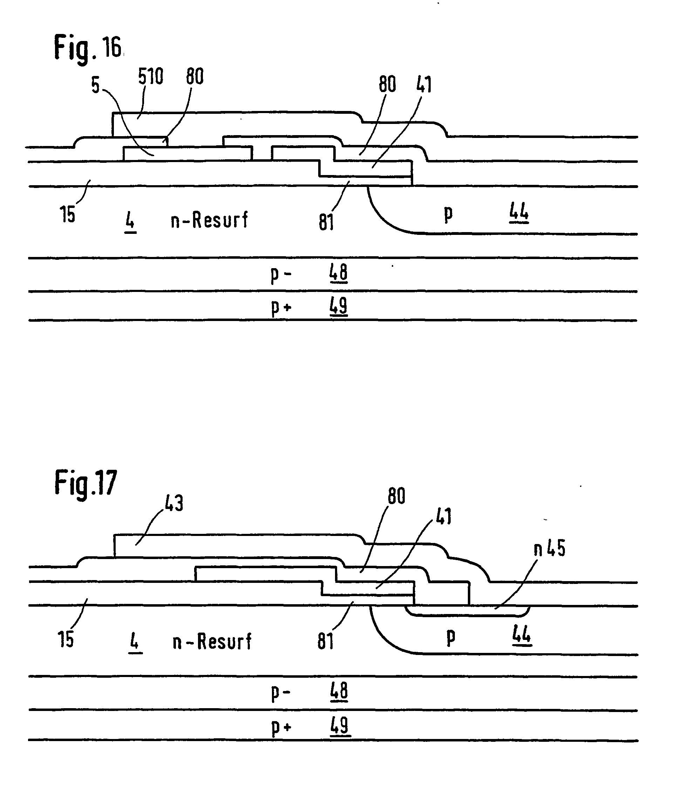

Die Figuren 16 und 17 zeigen Querschnittsbilder entlang der Schnitte CC' und DD' in Fig. 15 ohne die nach dem Stand der Technik üblichen, über den Metallisierungen liegenden Passivierungsschichten. Das n-Gebiet 45 erstreckt sich nicht über den Bereich, über den die Metallzuleitung 510 verläuft, was der Erhöhung der Latch-up-Festigkeit des Bauelements dient. Das Zwischendielektrikum ist mit 80 bezeichnet, während das Gateoxid mit 81 bezeichnet ist.

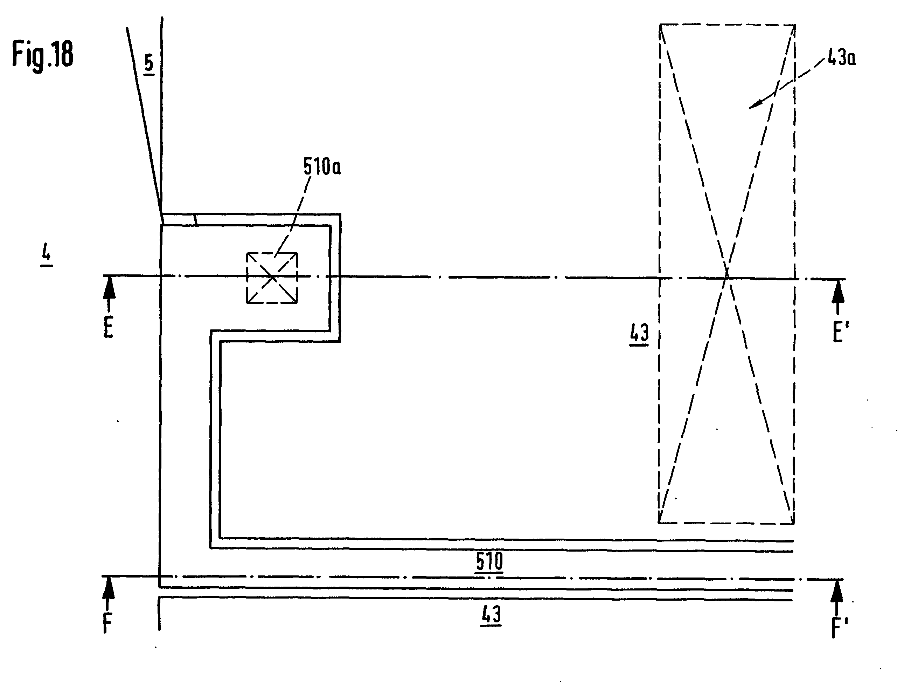

In Fig. 18 ist in Draufsicht eine weitere Realisierungsmöglichkeit mit Metallisierung und Zwischendielektrikum dargestellt. Das Ende des Poly-Silizium-Mäanders 5 wird so von der Metallzuleitung 510 kontaktiert, dass diese auf der dem Hochspannungsgebiet zugewandten Seite eine Flucht mit der Kathodenmetallisierung 43 bildet. Außerdem werden alle spitzen Ecken im Polysilizium von der Metallisierung verdeckt. Beide Maßnahmen halten Feldspitzen klein, die zu einer Reduktion der Durchbruchspannung des Bauelements führen können.

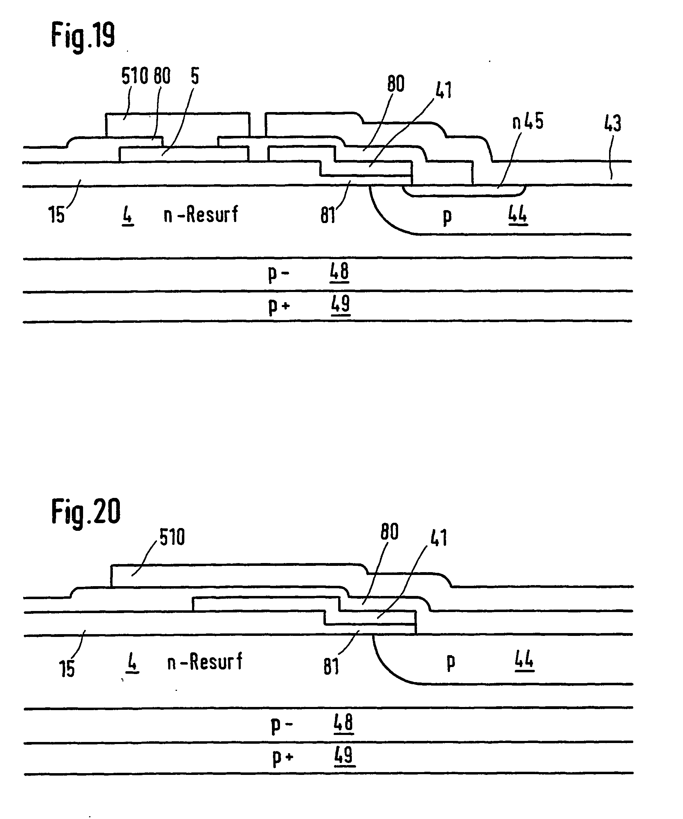

Die Figuren 19 und 20 zeigen Querschnittsbilder entlang der Schnitte EE' und FF' in Fig. 18 ohne die nach dem Stand der Technik üblichen, über den Metallisierungen liegenden Passivierungsschichten. Das n-Gebiet 45 erstreckt sich nicht über den Bereich, über den die Metallzuleitung 510 verläuft, was der Erhöhung der Latch-up-Festigkeit des Bauelements dient.

Die in den Figuren 18 bis 20 dargestellte Variante wird man wählen, wenn das zu kontaktierende Ende eines Poly-Silizium-Mäanders an einer im Bauelement so ungünstigen Stelle liegt, dass die in Verbindung mit den Figuren 14 bis 17 beschriebene Variante nicht umsetzbar ist.

Die Kontaktierung des hochspannungsseitigen Endes eines Poly-Silizium-Mäanders läßt sich entsprechend auszuführen.

## Patentansprüche

1. Halbleiter-Leistungsbauelement (1) mit einem zwischen Hochspannungsseite (2) und Niederspannungsseite (3) angeordneten Reduced SURface Field, RESURF-Gebiet (4), wobei mindestens ein Poly-Silizium (Si)-Widerstand (5) zur Signalübertragung zwischen Hochspannungsseite (2) und Niederspannungsseite (3) vorgesehen ist, dass der Poly-Si-Widerstand (5) über dem RESURF-Gebiet (4) angeordnet ist und dass der Poly-Si-Widerstand (5) von dem RESURF-Gebiet (4) elektrisch isoliert ist, **dadurch gekennzeichnet, dass** der Poly-Si-Widerstand (5) zumindest durch eine Feldoxidschicht (15) von dem RESURF-Gebiet (4) elektrisch isoliert ist und mindestens eine Senseschaltung (16) und mindestens eine Ansteuer- und Auswerteschaltung (17) zur Begrenzung von Überspannungen oder Durchlassströmen auf zulässige Maximalwerte vorgesehen ist und die Senseschaltung (16) auf dem Potential der Hochspannungsseite (2) liegt und die Ansteuer- und Auswerteschaltung (17) auf dem Potential der Niederspannungsseite (3) liegt.

2. Halbleiter-Leistungsbauelement (1) nach Anspruch 1, **dadurch gekennzeichnet, dass** der Poly-Si-Widerstand (5) mäanderförmig von der Hochspannungsseite (2) zur Niederspannungsseite (3) geführt ist

3. Halbleiter-Leistungsbauelement (1) nach einem der Ansprüche 1 oder 2, **dadurch gekennzeichnet, dass** der Poly-Si-Widerstand (5) als spiralförmiger Mäander von der Hochspannungsseite (2) zur Niederspannungsseite (3) geführt ist.

4. Halbleiter-Leistungsbauelement (1) nach einem der Ansprüche 1 oder 2, **dadurch gekennzeichnet, dass** der Poly-Si-Widerstand (5) in Form eines Zickzack-Mäanders von der Hochspannungsseite (2) zur Niederspannungsseite (3) geführt ist.

5. Halbleiter-Leistungsbauelement (1) nach einem der vorhergehenden Ansprüche **dadurch gekennzeichnet, dass** der Poly-Si-Widerstand (5) zur Signalübertragung zwischen Senseschaltung (16) und Ansteuer- und Auswerteschaltung (17) dient.

6. Halbleiter-Leistungsbauelement (1) nach Anspruch 5, **dadurch gekennzeichnet, dass** die Senseschaltung (16) und/oder die Ansteuer- und Auswerteschaltung (17) auf demselben Chip integriert sind wie das Leistungsbauelement (1).

7. Halbleiter-Diode 20) nach einem der Ansprüche 1 bis 6, **dadurch gekennzeichnet, dass** der Poly-Si-Widerstand (5) zur Signalübertragung zwischen Kathode (22) und Anode (21) dient.

8. Halbleiter-LIGBT (40) nach einem der Ansprüche 1 bis 6, **dadurch gekennzeichnet, dass** der Poly-Si-Widerstand (5) zur Signalübertragung zwischen Kathode (43) und Anode (42) dient.

9. Halbleiter-LDMOS (30) nach einem der Ansprüche 1 bis 6, **dadurch gekennzeichnet, dass** der Poly-Si-Widerstand (5) zur Signalübertragung zwischen Drain (33) und Source (32) dient.

10. Halbleiter-Bipolar-Transistor (10) nach einem der Ansprüche 1 bis 6, **dadurch gekennzeichnet, dass** der Poly-Si-Widerstand (5) zur Signalübertragung zwischen Emitter (12)und Kollektor (13) dient.

## Claims

1. Semiconductor power component (1) comprising a Reduced SURface Field, RESURF region (4), arranged between high-voltage side (2) and low-voltage side (3), at least one poly-Silicon (Si) resistor (5) being provided for signal transfer between high-voltage side (2) and low-voltage side (3), the poly-Si resistor (5) being arranged above the RESURF region (4), and the poly-Si resistor (5) being electrically insulated from the RESURF region (4), **characterized in that** the poly-Si resistor (5) is electrically insulated from the RESURF region (4) at least by a field oxide layer (15), and provision is made of at least one sense circuit (16) and at least one driving and evaluation circuit (17) for limiting overvoltages or forward currents to permissible maximum values, and the sense circuit (16) is at the potential of the high-voltage side (2) and the driving and evaluation circuit (17) is at the potential of the low-voltage side (3).

2. Semiconductor power component (1) according to Claim 1, **characterized in that** the poly-Si resistor (5) is led in meandering fashion from the high-voltage side (2) to the low-voltage side (3).

3. Semiconductor power component (1) according to either of Claims 1 and 2, **characterized in that** the poly-Si resistor (5) is led as a spiral meander from the high-voltage side (2) to the low-voltage side (3).

4. Semiconductor power component (1) according to either of Claims 1 and 2, **characterized in that** the poly-Si resistor (5) is led in the form of a zigzag meander from the high-voltage side (2) to the low-voltage side (3).

5. Semiconductor power component (1) according to one of the preceding claims, **characterized in that** the poly-Si resistor (5) serves for signal transfer between sense circuit (16) and driving and evaluation circuit (17).

6. Semiconductor power component (1) according to Claim 5, **characterized in that** the sense circuit (16) and/or the driving and evaluation circuit (17) are integrated on the same chip as the power component (1).

7. Semiconductor diode (20) according to one of Claims 1 to 6, **characterized in that** the poly-Si resistor (5) serves for signal transfer between cathode (22) and anode (21).

8. Semiconductor LIGBT (40) according to one of Claims 1 to 6, **characterized in that** the poly-Si resistor (5) serves for signal transfer between cathode (43) and anode (42).

9. Semiconductor LDMOS (30) according to one of Claims 1 to 6, **characterized in that** the poly-Si resistor (5) serves for signal transfer between drain (33) and source (32).

10. Semiconductor bipolar transistor (10) according to one of Claims 1 to 6, **characterized in that** the poly-Si resistor (5) serves for signal transfer between emitter (12) and collector (13).

## Revendications

1. Composant semi-conducteur de puissance (1) ayant un champ à surface réduite installé entre le côté haute tension (2) et le côté basse tension (3), une zone RESURF (4), au moins une résistance de polysilicium (Si) (5) pour transmettre les signaux entre le côté haute tension (2) et le côté basse tension (3),
la résistance de polysilicium (5) prévue sur la zone RESURF (4), en est isolée électriquement,
**caractérisé en ce que**
la résistance de polysilicium (5) est isolée électriquement de la zone RESURF (4) par au moins une couche d'oxyde de champ (15) et au moins un circuit de capteur (16) et sont prévus au moins un circuit de commande et d'exploitation (17) pour limiter les surtensions ou les courants à des valeurs maximales autorisées, et le circuit de capteur (16) est mis au potentiel du côté haute tension (2), le circuit de commande et d'exploitation (17) étant au potentiel du côté basse pression.

2. Composant semi-conducteur de puissance (1) selon la revendication 1,
**caractérisé en ce que**
la résistance de polysilicium (5) est tracée avec une forme de méandre à partir du côté haute tension (2) vers le côté basse tension (3).

3. Composant semi-conducteur de puissance (1) selon l'une quelconque des revendications 1 ou 2,
**caractérisé en ce que**
la résistance de polysilicium (5) est tracée suivant des méandres en spirale entre le côté haute tension (2) et le côté basse tension (3).

4. Composant semi-conducteur de puissance (1) selon l'une quelconque des revendications 1 ou 2,
**caractérisé en ce que**
la résistance de polysilicium (5) est sous la forme de méandres en zigzag entre le côté haute tension (2) et le côté basse tension (3).

5. Composant semi-conducteur de puissance (1) selon l'une quelconque des revendications précédentes,
**caractérisé en ce que**
la résistance de polysilicium (5) transmet les signaux entre un circuit de capteur (16) et un circuit de commande et d'exploitation (17).

6. Composant semi-conducteur de puissance (1) selon la revendication 5,
**caractérisé en ce que**
le circuit de capteur (16) et/ou le circuit de commande et d'exploitation (17) sont intégrés dans la même puce que le composant de puissance (1).

7. Diode semi-conductrice (20) selon l'une quelconque des revendications 1 à 6,
**caractérisée en ce que**
la résistance de polysilicium (5) transmet les signaux entre la cathode (22) et l'anode (21).

8. Semi-conducteur LIGBT (40) selon l'une quelconque des revendications 1 à 6,
**caractérisé en ce que**
la résistance de polysilicium (5) transmet les signaux entre la cathode (43) et l'anode (42).

9. Semi-conducteur LDMOS (30) selon l'une quelconque des revendications 1 à 6,
**caractérisé en ce que**
la résistance de polysilicium (5) transmet les signaux entre le drain (33) et la source (32).

10. Semi-conducteur transistor bipolaire (10) selon l'une quelconque des revendications 1 à 6,
**caractérisé en ce que**
la résistance de polysilicium (5) transmet les signaux entre l'émetteur (12) et le collecteur (13).
